# EUROPEAN PATENT APPLICATION

(11) **EP 2 352 065 A1**
(43) Date of publication of application: **03.08.2011**
(21) Application number: 09824904.8
(22) Date of filing: 05.11.2009
(51) Int. Cl.: G03F 7/032, C08F 290/14, C08G 59/20, C09J 7/00

(54) **PHOTOSENSITIVE RESIN COMPOSITION, PHOTOSENSITIVE ADHESIVE FILM, AND LIGHT-RECEIVING DEVICE**

(30) Priority: 07.11.2008 JP 2008286140
(71) Applicant: Sumitomo Bakelite Co., Ltd., Shinagawa-ku Tokyo 140-0002 (JP)
(72) Inventor: TAKAHASHI, Toyosei, Tokyo 140-0002 (JP); SHIRAISHI, Fumihiro, Tokyo 140-0002 (JP); SATO, Toshihiro, Tokyo 140-0002 (JP)
(74) Representative: Müller-Boré & Partner Patentanwälte
(86) International application number: PCT/JP2009/069232
(87) International publication number: WO 2010/053207

(57) **Abstract**

A photosensitive resin composition includes (A) an alkali-soluble resin, (B) an epoxy resin, and (C) a photopolymerization initiator, the epoxy resin (B) being an epoxy resin having a naphthalene skeleton and/or an epoxy resin having a triphenylmethane skeleton. A semiconductor device including a semiconductor wafer, a transparent substrate, and a spacer formed by a photosensitive adhesive film produced using the photosensitive resin composition does not suffer from condensation of dew. A light-receiving device having excellent reliability can also be obtained.

## Description

### TECHNICAL FIELD

The present invention relates to a photosensitive resin composition, a photosensitive adhesive film, and a light-receiving device.

### BACKGROUND ART

A photosensitive adhesive film may be bonded to a semiconductor wafer or the like, patterned by exposure and development, and bonded to a transparent substrate such as a glass substrate (see Patent Document 1, for example). In this case, the patterned photosensitive adhesive film serves as a spacer between the semiconductor wafer and the transparent substrate.

### (Related-art Document)

(Patent Document 1) JP-A-2006-323089 (claims)

### SUMMARY OF THE INVENTION

### PROBLEMS TO BE SOLVED BY THE INVENTION

When forming a spacer using a related-art photosensitive adhesive film, condensation of dew may occur between a semiconductor wafer and a transparent substrate in a high-temperature/high-humidity environment, so that the semiconductor device may malfunction.

### MEANS FOR SOLVING THE PROBLEMS

In view of the above situation, an object of the invention is to provide a photosensitive resin composition that prevents a situation in which a semiconductor device including a semiconductor wafer, a transparent substrate, and a spacer formed by a photosensitive adhesive film produced using the photosensitive resin composition suffers from condensation of dew, a photosensitive adhesive film using the same, and a light-receiving device.

The above object can be achieved by the following (see (1) to (13)).
(1) A photosensitive resin composition including (A) an alkali-soluble resin, (B) an epoxy resin, and (C) a photopolymerization initiator, the epoxy resin (B) being an epoxy resin having a naphthalene skeleton and/or an epoxy resin having a triphenylmethane skeleton.
(2) The photosensitive resin composition according to (1), wherein the epoxy resin (B) is an epoxy resin having a naphthalene skeleton shown by the following general formula (1) and/or an epoxy resin having a triphenylmethane skeleton shown by the following general formula (2). 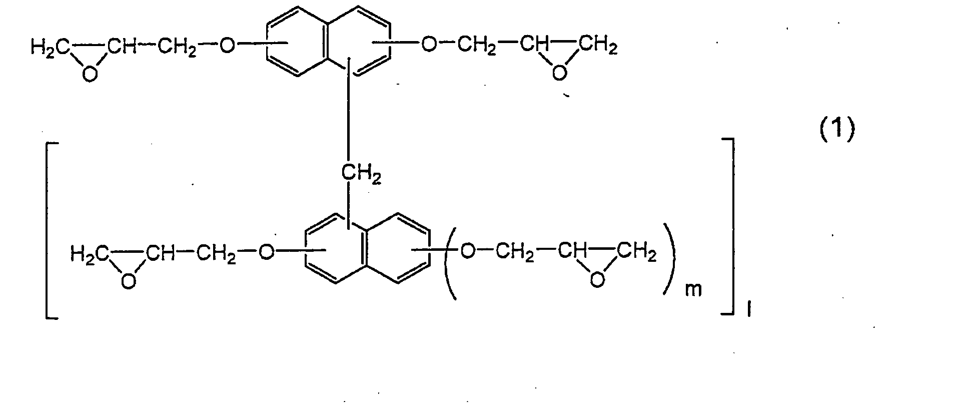 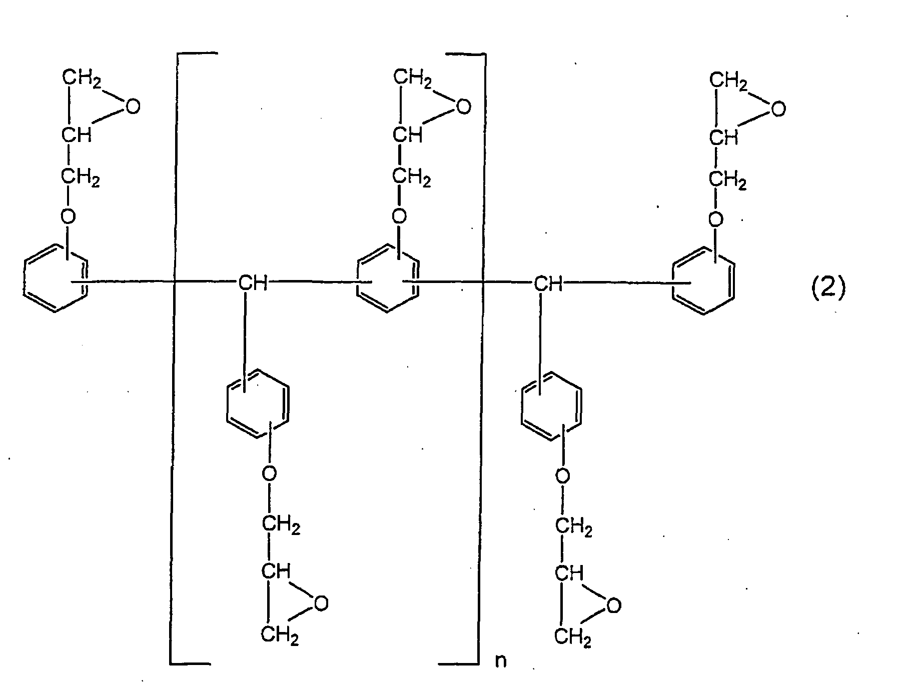
(3) The photosensitive resin composition according to (1), wherein the epoxy resin (B) is an epoxy resin having a naphthalene skeleton shown by the following general formula (3) and/or a mixture of epoxy resins having a triphenylmethane skeleton shown by the general formula (2) that differ in n, the average value of n being 0 to 0.8. 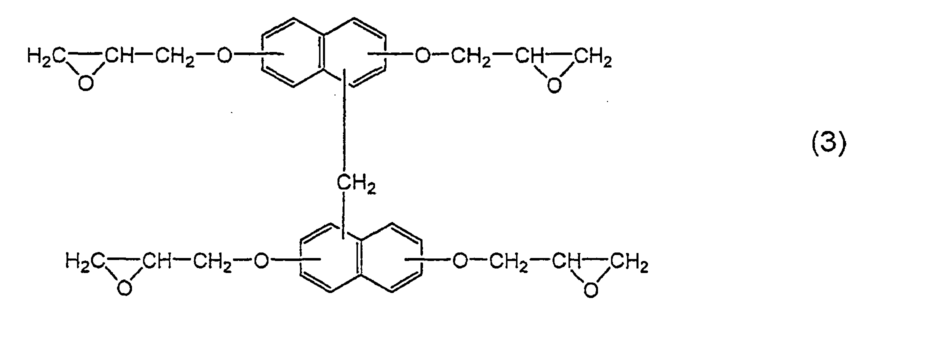 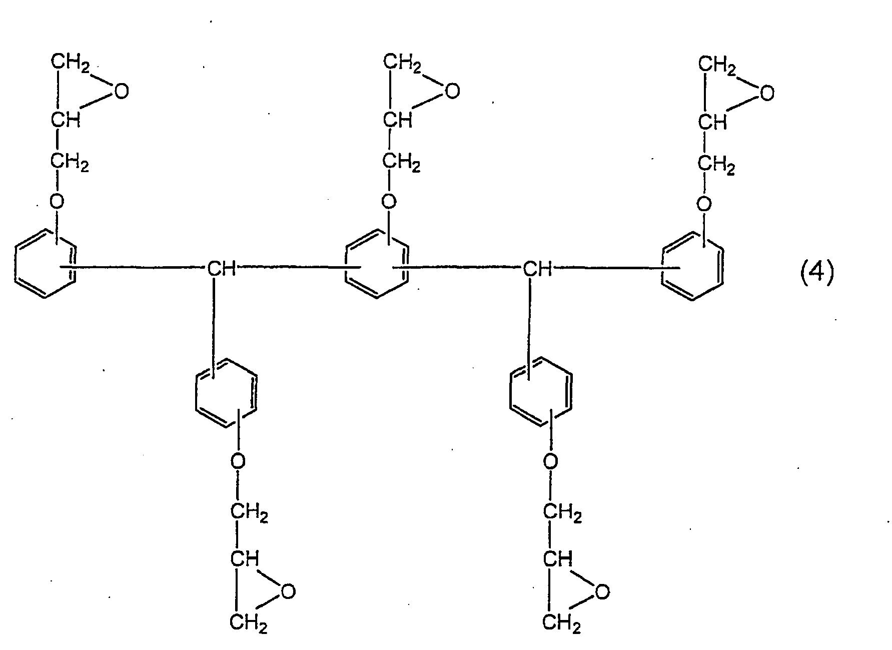
(4) The photosensitive resin composition according to any one of (1) to (3), the composition including the epoxy resin (B) in an amount of 5 to 50 wt%.
(5) The photosensitive resin composition according to any one of (1) to (4), wherein the alkali-soluble resin (A) includes a photopolymerizable double bond and an alkali-soluble group.
(6) The photosensitive resin composition according to any one of (1) to (5), wherein the alkali-soluble resin (A) is a (meth)acryl-modified phenol resin.
(7) The photosensitive resin composition according to any one of (1) to (6), further including a photopolymerizable compound that includes a hydrophilic group or a hydrophilic structure.
(8) The photosensitive resin composition according to any one of (1) to (7), further including a polyfunctional photopolymerizable compound.
(9) The photosensitive resin composition according to any one of (1) to (8), the composition including an inorganic filler in an amount of 0 to 5 wt%.
(10) The photosensitive resin composition according to any one of (1) to (9), the composition being used to form a spacer of a light-receiving device, the light-receiving device including a substrate on which a semiconductor element is mounted, a transparent substrate that is placed opposite to the substrate, and the spacer that defines a space formed between the substrate and the transparent substrate.
(11) A photosensitive adhesive film including the photosensitive resin composition according to any one of (1) to (9).
(12) A light-receiving device including a substrate on which a semiconductor element is mounted, a transparent substrate that is placed opposite to the substrate, and a spacer that defines a space formed between the substrate and the transparent substrate, the spacer being a cured product of the photosensitive resin composition according to any one of (1) to (9).

### EFFECTS OF THE INVENTION

According to the invention, a semiconductor device including a semiconductor wafer, a transparent substrate, and a spacer formed by a photosensitive adhesive film produced using the photosensitive resin composition does not suffer from condensation of dew. According to the invention, a light-receiving device having excellent reliability can also be obtained.

### BRIEF DESCRIPTION OF THE DRAWING

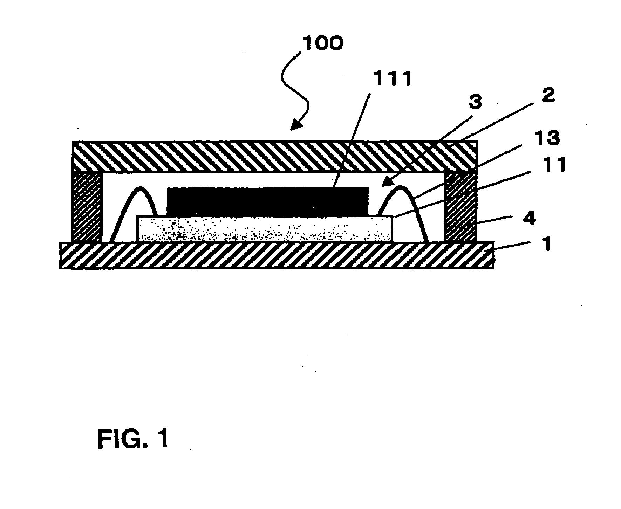

FIG 1 is a cross-sectional view showing an example of a light-receiving device according to one embodiment of the invention.

### DESCRIPTION OF EXEMPLARY EMBODIMENTS

A photosensitive resin composition, an adhesive film, and a light-receiving device according to embodiments of the invention are described below.

A photosensitive resin composition according to one embodiment of the invention includes (A) an alkali-soluble resin, (B) an epoxy resin, and (C) a photoinitiator, the epoxy resin (B) being an epoxy resin having a naphthalene skeleton and/or an epoxy resin having a triphenylmethane skeleton.

A photosensitive adhesive film according to one embodiment of the invention includes the photosensitive resin composition according to one embodiment of the invention.

A light-receiving device according to one embodiment of the invention includes a substrate on which a semiconductor element is mounted, a transparent substrate that is placed opposite to the substrate, and a spacer that defines a space formed between the substrate and the transparent substrate, the spacer being a cured product of the photosensitive resin composition according to one embodiment of the invention.

A photosensitive resin composition, a photosensitive adhesive film, and a light-receiving device according to preferred embodiments of the invention are described below with reference to FIG 1.

### (Light-receiving device)

FIG. 1 is a cross-sectional view showing an example of a light-receiving device according to one embodiment of the invention. A light-receiving device 100 shown in FIG 1 includes a substrate 1 on which a semiconductor element 11 is mounted, a transparent substrate 2 that is placed opposite to the substrate 1, and a spacer 4 that defines a space 3 formed between the substrate 1 and the transparent substrate 2. The semiconductor element 11 includes a light-receiving section 111. The semiconductor element 11 and the substrate 1 are electrically connected via bonding wires 13.

### (Photosensitive resin composition)

The spacer 4 is a cured product of a photosensitive resin composition according to one embodiment of the invention.

The photosensitive resin composition according to one embodiment of the invention includes (A) an alkali-soluble resin, (B) an epoxy resin, and (C) a photoinitiator, the epoxy resin (B) being an epoxy resin having a naphthalene skeleton and/or an epoxy resin having a triphenylmethane skeleton.

The photosensitive resin composition according to one embodiment of the invention is a negative-type photosensitive resin composition (i.e., a photopolymerizable photosensitive resin composition that is polymerized by applying light). Examples of the photosensitive resin composition according to one embodiment of the invention include the following photosensitive resin compositions.
(I) A photosensitive resin composition including (A-2) an alkali-soluble resin that includes a photopolymerizable double bond and an alkali-soluble group, (B) an epoxy resin, and (C) a photoinitiator.
(II) Aphotosensitive resin composition including (A-1) an alkali-soluble resin that does not include a photopolymerizable double bond, but includes an alkali-soluble group, (B) an epoxy resin, and (C) a photoinitiator.
(III) A photosensitive resin composition including (A-1) an alkali-soluble resin that does not include a photopolymerizable double bond, but includes an alkali-soluble group, (B) an epoxy resin, (C) a photoinitiator, and (D) a photopolymerizable compound.
(IV) A photosensitive resin composition including (A-2) an alkali-soluble resin that includes a photopolymerizable double bond and an alkali-soluble group, (B) an epoxy resin, (C) a photoinitiator, and (D) a photopolymerizable compound.
(V) A photosensitive resin composition including (A-1) an alkali-soluble resin that does not include a photopolymerizable double bond, but includes an alkali-soluble group, (A-2) an alkali-soluble resin that includes a photopolymerizable double bond and an alkali-soluble group, (B) an epoxy resin, (C) a photoinitiator, and (D) a photopolymerizable compound.

The photosensitive resin composition according to one embodiment of the invention includes the alkali-soluble resin (A). When the alkali-soluble resin (A) is irradiated and developed using an alkaline developer, the unexposed area is dissolved and removed in the alkaline developer. Therefore, the photosensitive resin composition that includes the alkali-soluble resin (A) can be selectively patterned by applying light.

The alkali-soluble resin (A) is a resin that is soluble in an alkaline developer, and includes an alkali-soluble group in the molecule. The alkali-soluble group is a phenolic hydroxyl group (i.e., a hydroxyl group bonded to an aromatic ring) or a carboxyl group.

The alkali-soluble resin (A) that includes a phenolic hydroxyl group or a carboxyl group functions as a curing agent for the epoxy resin (B).

The alkali-soluble resin (A) may be (A-1) an alkali-soluble resin that does not include a photopolymerizable double bond, but includes an alkali-soluble group, or (A-2) an alkali-soluble resin that includes a photopolymerizable double bond and an alkali-soluble group. The term "photopolymerizable double bond" refers to a group that undergoes a polymerization reaction with a photopolymerizable double bond included in another molecule upon irradiation. Examples of the photopolymerizable double bond include a double bond included in a substituent such as a vinyl group, a (meth)acrylic group, or an allyl group, and a double bond in the main molecular chain.

Examples of the alkali-soluble resin (A-1) include novolac resins (e.g., cresol novolac resin, phenol novolac resin, bisphenol A novolac resin, bisphenol F novolac resin, catechol novolac resin, resorcinol novolac resin, and pyrogallol novolac resin), phenolaralkyl resins, triphenylmethane phenol resins, biphenylaralkyl phenol resins, α-naphtholaralkyl phenol resins, β-naphtholaralkyl phenol resins, hydroxystyrene resins, acrylic resins such as methacrylic acid resins and methacrylate acid ester resins, cyclic olefin resins including a hydroxyl group, a carboxyl group, or the like, polyamide resins (e.g., a resin that has at least one of a polybenzoxazole structure and a polyimide structure, and includes a hydroxyl group, a carboxyl group, an ether group, or an ester group in the main chain or side chain, a resin that has a polybenzoxazole precursor structure, a resin that has a polyimide precursor structure, and a resin that has a polyamidate acid ester structure), and the like. These resins include a phenolic hydroxyl group or a carboxyl group (alkali-soluble group) in the molecule. Note that the alkali-soluble resin (A-1) includes low-molecular-weight compounds including only one repeating unit (e.g., cresol, bisphenol A, bisphenol F, catechol, resorcinol, and pyrogallol), and high-molecular-weight compounds including two or more repeating units (e.g., cresol novolac resin, phenol novolac resin, bisphenol A novolac resin, bisphenol F novolac resin, catechol novolac resin, resorcinol novolac resin, and pyrogallol novolac resin).

The alkali-soluble resin (A) may be a thermoplastic resin such as a carboxyl group-containing acrylic resin.

Examples of the alkali-soluble resin (A-2) include resins produced by introducing a double bond-containing group into an alkali-soluble group-containing resin (e.g., alkali-soluble resin (A-1)); resins produced by introducing an alkali-soluble group into a photopolymerizable double bond-containing resin; polymers of monomers including both an alkali-soluble group and a photopolymerizable double bond (e.g., (meth)acryloyl group-containing acrylic acid polymer), and the like. Note that the term "(meth)acryl" used herein refers to acryl or methacryl, and the term "(meth)acryloyl" used herein refers to acryloyl or methacryloyl.

Examples of the alkali-soluble resin (A-2) produced by introducing a double bond-containing group into an alkali-soluble group-containing resin (e.g., alkali-soluble resin (A-1)) include a (meth)acryl-modified phenol resin obtained by reacting (meth)acryl glycidyl ether with a phenolic hydroxyl group of a phenol resin, a (meth)acryl-modified bisphenol obtained by reacting (meth)acryl glycidyl ether with a hydroxyl group of a bisphenol compound (e.g., bisphenol A), and the like. Examples of a resin produced by introducing an alkali-soluble group into a resin that includes a photopolymerizable double bond include a resin obtained by reacting hydroxyl groups of a bisphenol compound with an epoxy group of a compound that includes a (meth)acrylic group and an epoxy group (e.g., (meth)acryl glycidyl ether), and reacting an acid anhydride with a hydroxyl group of the resulting resin to introduce a carboxyl group, a resin obtained by reacting hydroxyl groups of a bisphenol compound with an epoxy group of a compound that includes a (meth)acrylic group and an epoxy group (e.g., (meth)acryl glycidyl ether), and reacting a dicarboxylic acid with a hydroxyl group of the resulting resin to introduce a carboxyl group, and the like.

Among these alkali-soluble resins (A), the alkali-soluble resin (A-2) is preferable, and a (meth)acryl-modified phenol resin is particularly preferable.

The alkali-soluble resin (A) may include an alcoholic hydroxyl group, an epoxy group, an amino group, or a cyanate group.

When using the alkali-soluble resin (A-2), a resin having an unreacted double bond can be removed during development using an alkaline aqueous solution that has less environmental load as a developer instead of an organic solvent. Moreover, since a double bond contributes to a curing reaction, the heat resistance of the photosensitive resin composition can be improved.

When using the alkali-soluble resin (A-2) produced by introducing a double bond-containing group into an alkali-soluble group-containing resin (e.g., alkali-soluble resin (A-1)), the alkali-soluble group equivalent (molecular weight/number of alkali-soluble groups) is not particularly limited, but is preferably 30 to 2000, and particularly preferably 50 to 1000. If the alkali-soluble group equivalent exceeds 2000, development may take time due to a decrease in alkali developability. If the alkali-soluble group equivalent is less than 30, the alkali development resistance of the exposed area may decrease. The alkali-soluble group equivalent is calculated using the weight average molecular weight as the molecular weight.

When using a resin obtained by reacting both hydroxyl groups of a bisphenol compound with an epoxy group of a compound that includes a (meth)acrylic group and an epoxy group (e.g., (meth)acryl glycidyl ether), and reacting an acid anhydride or a dicarboxylic acid with a hydroxyl group of the resulting resin to introduce a carboxyl group, the alkali-soluble group equivalent (molecular weight/number of alkali-soluble groups) is not particularly limited, but is preferably 30 to 2000, and particularly preferably 50 to 1000. If the alkali-soluble group equivalent exceeds 2000, development may take time due to a decrease in alkali developability. If the alkali-soluble group equivalent is less than 30, the alkali development resistance of the exposed area may decrease.

The weight average molecular weight of the alkali-soluble resin (A) is not particularly limited, but is preferably 300,000 or less, and particularly preferably 5000 to 150,000. If the weight average molecular weight of the alkali-soluble resin (A) is within the above range, the spacer 4 can be advantageously formed.

The weight average molecular weight of the alkali-soluble resin (A) is determined by gel permeation chromatography (GPC) using a calibration curve prepared using styrene as a standard substance. Tetrahydrofuran (THF) is used as a solvent, and the measurement temperature is 40°C.

The content of the alkali-soluble resin (A) in the photosensitive resin composition according to one embodiment of the invention is not particularly limited. When the photosensitive resin composition does not include inorganic fillers (described later), the content of the alkali-soluble resin (A) in the photosensitive resin composition is 10 to 80wt%, and preferably 15 to 70 wt%. When the photosensitive resin composition includes inorganic fillers, the content of the alkali-soluble resin (A) in the photosensitive resin composition is preferably 15 to 60wt%, and particularly preferably 20 to 50 wt%, based on the total amount of the components excluding the inorganic filler. If the content of the alkali-soluble resin (A) is less than the lower limit, mutual solubility with the epoxy resin (B) and the photopolymerizable compound (D) may decrease, and it may be impossible to develop the photosensitive resin composition using an alkali. If the content of the alkali-soluble resin (A) exceeds the upper limit, a decrease in developability, or a decrease in resolution when patterning an adhesive layer by photolithography, may occur.

The photosensitive resin composition according to one embodiment of the invention includes the epoxy resin (B). The epoxy resin (B) is an epoxy resin having a naphthalene skeleton and/or an epoxy resin having a triphenylmethane skeleton (i.e., at least one of (one or both of) an epoxy resin having a naphthalene skeleton and/or an epoxy resin having a triphenylmethane skeleton). Since a product of the photosensitive resin composition according to one embodiment of the invention that includes the epoxy resin (B) includes a naphthalene skeleton and/or a triphenylmethane skeleton, the free volume of the cured product of the photosensitive resin composition increases. Therefore, when bonding a transparent substrate to a substrate on which a semiconductor element is mounted using a photosensitive adhesive film that includes the photosensitive resin composition according to one embodiment of the invention as a spacer to produce a semiconductor device having a hollow structure, moisture (water) can be removed from the hollow area through the spacer due to an increase in free volume, so that condensation of dew on the transparent substrate positioned within the hollow area can be prevented. Since a naphthalene skeleton and a triphenylmethane skeleton exhibit high heat resistance, a highly reliable semiconductor device can be obtained.

Note that epoxy resins (B) having a naphthalene skeleton may be used singly or in combination of two or more of them. Likewise, epoxy resins (B) having a triphenylmethane skeleton may be used singly or in combination of two or more of them.

The molecular weight of the epoxy resin (B) is not particularly limited insofar as the epoxy resin (B) is thermally cured through a reaction with a curing agent. The weight average molecular weight of the epoxy resin (B) is preferably 100 to 5000.

The content of the epoxy resin (B) in the photosensitive resin composition according to one embodiment of the invention is not particularly limited, but is preferably 5 to 50 wt%, and particularly preferably 10 to 45 wt%. If the content of the epoxy resin (B) is within the above range, the resulting photosensitive adhesive film exhibits excellent curability and heat resistance (after curing), and condensation of dew can be advantageously prevented.

Examples of the epoxy resin (B) having a naphthalene skeleton include, but not limited to, an epoxy resin having a naphthalene skeleton shown by the following general formula (1). Note that epoxy resins having a naphthalene skeleton shown by the general formula (1) may be used singly or in combination of two or more of them.

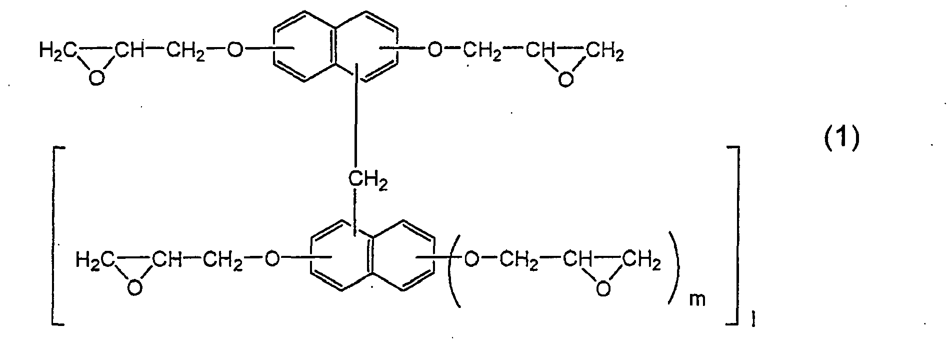

When the photosensitive resin composition according to one embodiment of the invention includes the epoxy resin having a naphthalene skeleton shown by the general formula (1), a photosensitive adhesive film that exhibits excellent thermal curability and excellent adhesion to a transparent substrate and a substrate on which a semiconductor element is mounted, and advantageously prevents condensation of dew can be obtained.

1 and m in the general formula (1) are 0 or 1. It is preferable that and m be 1 in order to improve the effect of preventing condensation of dew.

Examples of the epoxy resinhaving a naphthalene skeleton shown by the general formula (1) include, but not limited to, an epoxy resin having a naphthalene skeleton shown by the following general formula (3), an epoxy resin having a naphthalene skeleton shown by the following general formula (8), and an epoxy resin having a naphthalene skeleton shown by the following general formula (9). It is preferable to use epoxy resins having a naphthalene skeleton shown by the following general formula (5). The epoxy resin having a naphthalene skeleton shown by the general formula (3), the epoxy resin having a naphthalene skeleton shown by the general formula (8), the epoxy resin having a naphthalene skeleton shown by the following general formula (9), and the epoxy resins having a naphthalene skeleton shown by the general formula (5) may be used either individually or in combination.

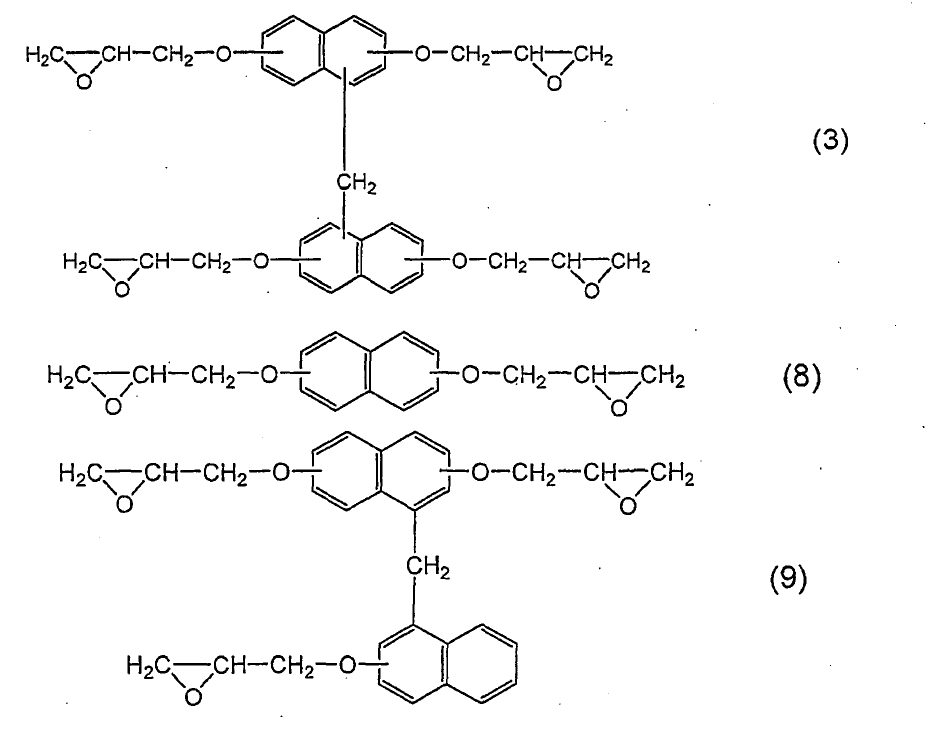

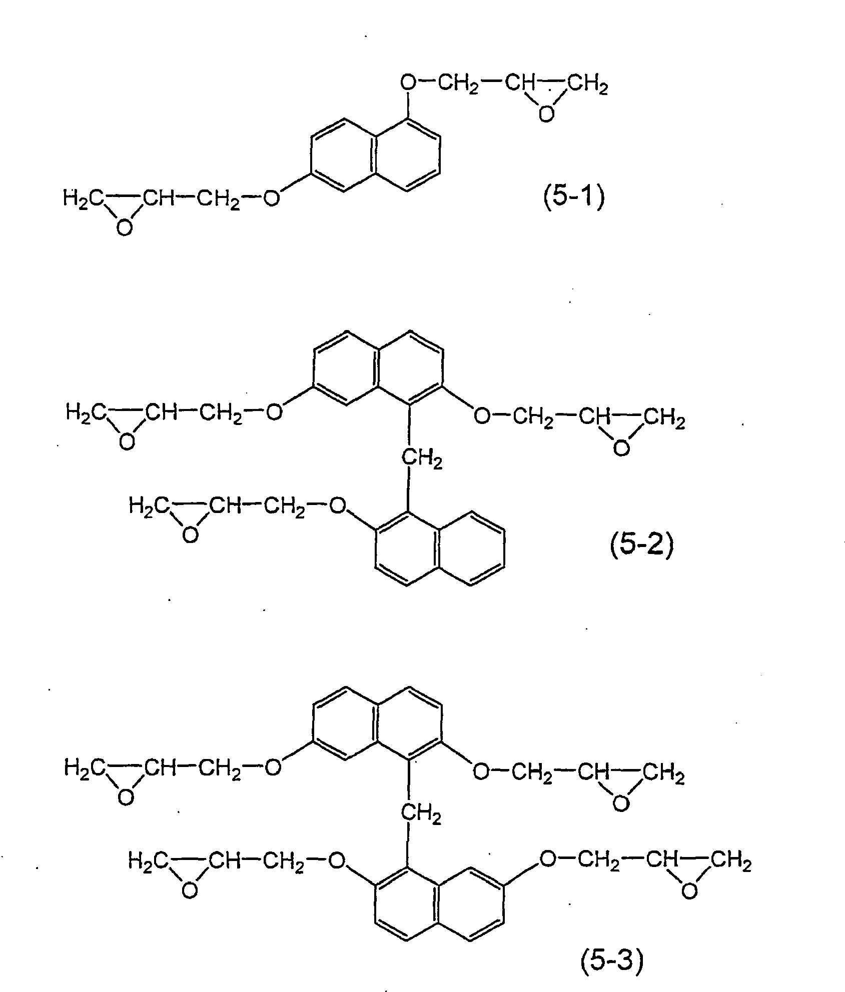

Examples of the epoxy resin (B) having a triphenylmethane skeleton include, but not limited to, an epoxy resin having a triphenylmethane skeleton shown by the following general formula (2). Note that epoxy resins having a triphenylmethane skeleton shown by the general formula (2) may be used singly or in combination of two or more of them.

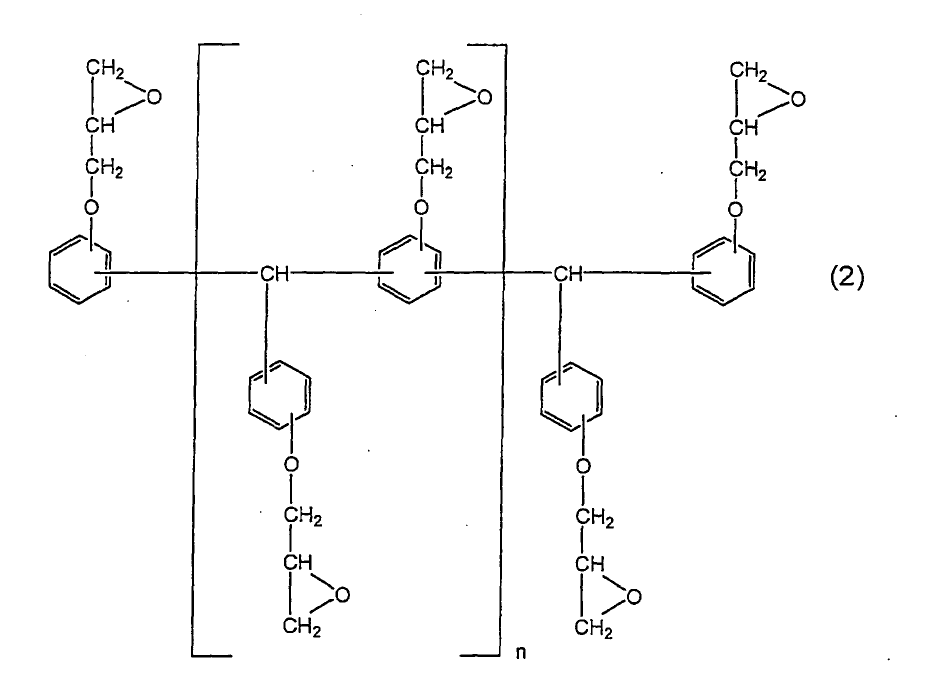

When the photosensitive resin composition according to one embodiment of the invention includes the epoxy resin having a triphenylmethane skeleton shown by the general formula (2), a photosensitive adhesive film that exhibits excellent thermal curability and excellent adhesion to a transparent substrate and a substrate on which a semiconductor element is mounted, and advantageously prevents condensation of dew can be obtained.

n in the general formula (2) is an integer from 0 to 10. It is preferable that n is 0 to 5 in order to improve the effect of preventing condensation of dew, and improve the mechanical properties of the cured photosensitive adhesive film.

Examples of the epoxy resin having a triphenylmethane skeleton shown by the general formula (2) include, but not limited to, epoxy resins having a triphenylmethane skeleton shown by the following general formula (4).

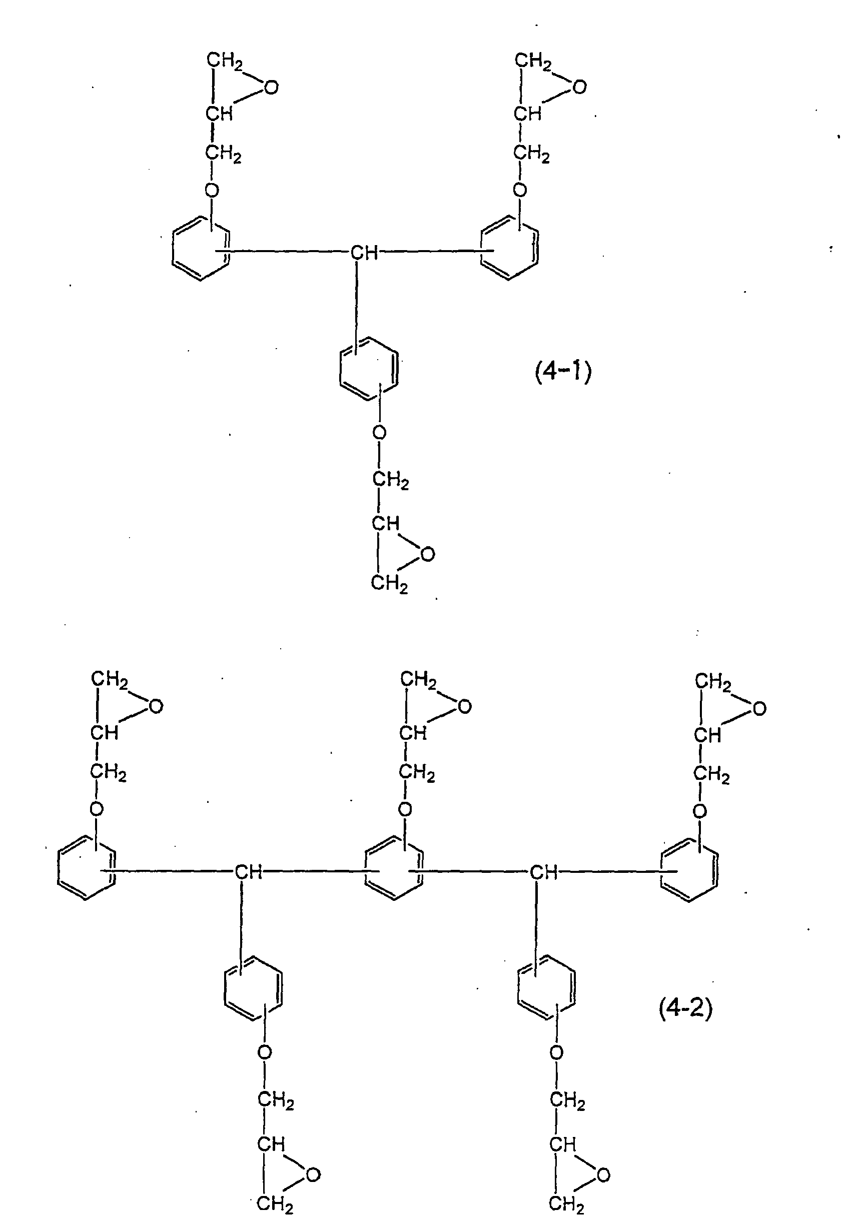

The epoxy resin (B) may be a mixture of epoxy resins having a triphenylmethane skeleton shown by the general formula (2) that differ in n. In this case, the average value of n of the epoxy resins having a triphenylmethane skeleton shown by the general formula (2) is preferably 0 to 0.8, and particularly preferably 0.1 to 0.5.

The epoxy resin (B) is preferably an epoxy resin having a naphthalene skeleton shown by the general formula (1) and/or an epoxy resin having a triphenylmethane skeleton shown by the general formula (2), more preferably at least one of the epoxy resins having a naphthalene skeleton shown by the general formulas (3), (8), and (9) and/or a mixture of epoxy resins having a triphenylmethane skeleton shown by the general formula (2) that differ in n, the average value of n being 0 to 0.8, and preferably 0.1 to 0.5, and particularly preferably at least one of the epoxy resins having a naphthalene skeleton shown by the general formula (5) and/or a mixture of epoxy resins having a triphenylmethane skeleton shown by the general formula (2) that differ in n, the average value of n being 0 to 0.8, and preferably 0.1 to 0.5.

It is preferable to use the epoxy resin (B) having a naphthalene skeleton and the epoxy resin (B) having a triphenylmethane skeleton in order to improve the effect of preventing condensation of dew and improve mutual solubility with other components. In this case, it is preferable to use the epoxy resin having a triphenylmethane skeleton in an amount of 5 parts by weight or more, and particularly preferably 10 to 1000 parts by weight, based on 100 parts by weight of the epoxy resin having a naphthalene skeleton, for example, but the amount is not limited to.

The photosensitive resin composition according to one embodiment of the invention includes the photoinitiator (C). The photoinitiator (C) improves the patterning capability of the photosensitive resin composition.

Examples of the photoinitiator (C) include, but not limited to, benzophenone, acetophenone, benzoin, benzoin isobutyl ether, methyl benzoin benzoate, benzoin benzoate, benzoin methyl ether, benzyl phenyl sulfide, benzyl compounds, benzyl methyl ketal, dibenzyl compounds, diacetyl compounds, and the like. Among these, benzophenone and benzyl methyl ketal are preferable in order to obtain an excellent patterning capability.

The content of the photoinitiator (C) in the photosensitive resin composition according to one embodiment of the invention is not particularly limited, but is preferably 0.5 to 5 wt%, and particularly preferably 1 to 3 wt%. If the content of the photoinitiator (C) is less than 0.5 wt%, the effect of initiating photopolymerization may decrease. If the content of the photoinitiator (C) exceeds 5 wt%, the storage stability of the photosensitive resin composition or the resolution after patterning may decrease due to an increase in reactivity. A photosensitive resin composition that exhibits a photopolymerization initiation effect and storage stability in a well-balanced manner can be obtained by adjusting the content of the photoinitiator (C) in the photosensitive resin composition within the above range.

The photosensitive resin composition according to one embodiment of the invention may include the photopolymerizable compound (D). When the alkali-soluble resin (A) does not include a photopolymerizable double bond, the photosensitive resin composition according to one embodiment of the invention includes the photopolymerizable compound (D).

The photopolymerizable compound (D) undergoes photopolymerization upon irradiation of light, and includes a photopolymerizable double bond. Examples of the photopolymerizable compound (D) include photopolymerizable monomers and photopolymerizable oligomers including a photopolymerizable double bond, resins including a photopolymerizable double bond in the main chain or side chain, and the like.

Examples of the photopolymerizable monomers include bisphenol A ethylene glycol-modified di(meth)acrylates, isocyanuric acid ethylene glycol-modified di(meth)acrylates, tripropylene glycol di(meth)acrylate, pentaerythritol di(meth)acrylate monostearate, tetraethylene glycol di(meth)acrylate, polyethylene glycol di(meth)acrylate, pentaerythritol tri(meth)acrylate, trimethylolpropane tri (meth)acrylate, trimethylolpropane propylene glycol tri(meth)acrylate, trimethylolpropane ethylene glycol tri(meth)acrylate, isocyanuric acid ethylene glycol-modified tri(meth)acrylates, dipentaerythritol penta(meth)acrylate, dipentaerythritol hexa(meth)acrylate, pentaerythritol tetra(meth)acrylate, and the like.

Examples of the photopolymerizable oligomers include urethane (meth)acrylates, epoxy (meth)acrylates, and the like.

Examples of the resins including a photopolymerizable double bond in the main chain or side chain include a resin obtained by reacting a glycidyl group of glycidyl (meth)acrylate with a carboxyl group of a (meth)acrylic resin having a (meth)acrylic acid structural unit, and a resin obtained by reacting a carboxyl group of (meth)acrylic acid with a glycidyl group of a (meth)acrylic resin having a glycidyl (meth)acrylate structural unit. The resins including a photopolymerizable double bond in the main chain or side chain preferably have a molecular weight of 50 to 5000.

Further examples of the photopolymerizable compound (D) include a photopolymerizable compound(D-1) that includes a hydrophilic group or a hydrophilic structure. When the photosensitive resin composition according to one embodiment of the invention includes the photopolymerizable compound (D-1) that includes a hydrophilic group or a hydrophilic structure, residues after patterning can be reduced. Examples of the hydrophilic group or the hydrophilic structure include hydrophilic groups such as an alcoholic hydroxyl group, and hydrophilic structures such as an oxyethylene structure and an oxypropylene structure.

It is considered that residues after patterning can be reduced when the photosensitive resin composition according to one embodiment of the invention includes the photopolymerizable compound (D-1) that includes a hydrophilic group or a hydrophilic structure since the photosensitive resin composition is easily dissolved in an alkaline developer due to an increase in affinity for water as a result of incorporating the hydrophilic group or the hydrophilic structure.

Examples of the photopolymerizable compound (D-1) that includes a hydrophilic group or a hydrophilic structure include an acrylic compound (D-1-1) that includes a hydroxyl group, an acrylic compound(D-1-2) that includes an oxyethylene structure or an oxypropylene structure, and the like. Acrylic compound (D-1-1) including hydroxyl group is preferably. The photosensitive resin composition according to one embodiment of the invention exhibits an excellent patterning capability (developability) when the photosensitive resin composition includes the acrylic compound (D-1-1) that includes a hydroxyl group or the acrylic compound (D-1-2) that includes an oxyethylene structure or an oxypropylene structure.

The acrylic compound (D-1-1) that includes a hydroxyl group is preferably a compound obtained by reacting (meth)acrylic acid with an epoxy group of an epoxy compound. Specific examples of such a compound include a compound obtained by adding methacrylic acid to ethylene glycol diglycidyl ether, a compound obtained by adding acrylic acid to ethylene glycol diglycidyl ether, a compound obtained by adding methacrylic acid to propylene glycol diglycidyl ether, a compound obtained by adding acrylic acid to propylene glycol diglycidyl ether, a compound obtained by adding methacrylic acid to tripropylene glycol diglycidyl ether, a compound obtained by adding acrylic acid to tripropylene glycol diglycidyl ether, a compound obtained by adding methacrylic acid to bisphenol A diglycidyl ether, a compound obtained by adding acrylic acid to bisphenol A diglycidyl ether, and the like.

The epoxy compound used to obtain the acrylic compound (D-1-1) that includes a hydroxyl group (i.e., the epoxy compound to which (meth)acrylic acid is added) is preferably an epoxy compound that includes an aromatic ring due to an excellent shape retention capability. The acrylic compound (D-1-1) that includes a hydroxyl group is preferably at least one compound selected from the compounds shown by the following formula (7) since the resulting spacer 4 can be provided with an excellent shape retention capability in addition to reducing residues.

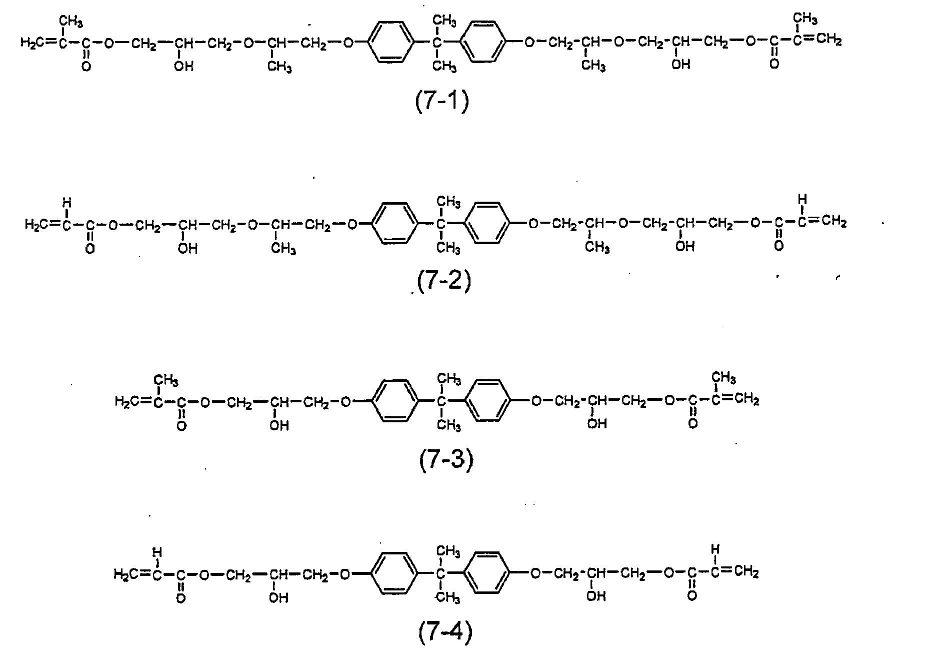

The content of the photopolymerizable compound (D-1) in the photosensitive resin composition according to one embodiment of the invention is not particularly limited, but is preferably 1 to 20 wt%, and particularly preferably 2 to 8 wt%. If the content of the photopolymerizable compound (D-1) is within the above range, the effect of reducing residues and the shape retention capability of the spacer 4 can be improved.

Further examples of the photopolymerizable compound (D) include a polyfunctional photopolymerizable compound(D-2). The polyfunctional photopolymerizable compound (D-2) improves the patterning capability of the photosensitive resin composition together with the alkali-soluble resin (A). The polyfunctional photopolymerizable compound (D-2) includes two or more photopolymerizable double bonds, and differs from the photopolymerizable compound (D-1) including hydrophilic group or structure. Specifically, the polyfunctional photopolymerizable compound (D-2) differs from the photopolymerizable compound (D-1) as to structure, molecular weight, and the like.

Examples of the polyfunctional photopolymerizable compound (D-2) include glycerol dimethacrylate, trimethylolpropane triacrylate, trimethylolpropane trimethacrylate, pentaerythritol triacylate, pentaerythritol tetraacrylate, dipentaerythritol hexaacrylate, and the like.

The polyfunctional photopolymerizable compound (D-2) is preferably a tri- or higher functional photopolymerizable compound. When the photosensitive resin composition according to one embodiment of the invention includes a tri- or higher functional photopolymerizable compound as the polyfunctional photopolymerizable compound (D-2), the spacer 4 exhibits an excellent shape retention capability even if the photosensitive resin composition substantially does not include a filler.

Examples of the tri- or higher functional photopolymerizable compound used as the polyfunctional photopolymerizable compound (D-2) include trimethylolpropane trimethacrylate, pentaerythritol triacylate, and the like. It is considered that the spacer 4 exhibits an excellent shape retention capability even if the photosensitive resin composition according to one embodiment of the invention substantially does not include a filler when the photosensitive resin composition includes a tri- or higher functional photopolymerizable compound as the polyfunctional photopolymerizable compound (D-2) since the photo-crosslink density increases due to a three-dimensional photo-crosslinking reaction, and a decrease in modulus of elasticity is prevented.

The content of the polyfunctional photopolymerizable compound (D-2) in the photosensitive resin composition according to one embodiment of the invention is not particularly limited, but is preferably 5 to 50 wt%, and particularly preferably 10 to 40 wt%. If the content of the polyfunctional photopolymerizable compound (D-2) exceeds 50 wt%, a decrease in adhesion may occur. If the content of the polyfunctional photopolymerizable compound (D-2) is less than 5 wt%, the shape retention capability may deteriorate.

A photosensitive resin composition that exhibits an excellent effect of reducing residues when forming the spacer 4 and exhibits an excellent shape retention capability can be obtained by utilizing the photopolymerizable compound (D-1) including hydrophilic group or structure and the polyfunctional photopolymerizable compound (D-2) (particularly a tri- or higher functional photopolymerizable compound) in combination. In this case, the ratio of the content of the photopolymerizable compound (D-1) including hydrophilic group or structure to the content of the polyfunctional photopolymerizable compound (D-2) is not particularly limited, but is preferably 0.05 to 1.5, and particularly preferably 0.1 to 1.0. If the ratio of the content of the photopolymerizable compound (D-1) including hydrophilic group or structure to the content of the polyfunctional photopolymerizable compound (D-2) is within the above range, excellent workability, microfabricatability, and reliability can be achieved in addition to the residue reduction effect and the shape retention effect.

The photosensitive resin composition according to one embodiment of the invention may include a thermosetting resin other than the epoxy resin (B). In this case, the heat resistance (i.e., reflow resistance at 240°C) of the photosensitive resin composition can be improved.

Examples of the thermosetting resin other than the epoxy resin (B) include novolac phenol resins (e.g., phenol novolac resin, cresol novolac resin, and bisphenol A novolac resin), phenol resins (e.g., resol phenol resin), bisphenol epoxy resins (e.g., bisphenol A epoxy resin and bisphenol F epoxy resin), novolac epoxy resins (e.g., novolac epoxy resin and cresol novolac epoxy resin), epoxy resins (e.g., biphenyl epoxy resin, stilbene epoxy resin, triazine nucleus-containing epoxy resin, dicyclopentadiene-modified phenol epoxy resin, and silicone-modified epoxy resin), urea resins, triazine ring-containing resins (e.g., melamine resin), unsaturated polyester resins, bismaleimide resins, polyurethane resins, diallyl phthalate resins, silicone resins, benzoxazine ring-containing resins, cyanate ester resins, and the like. These resins may be used either individually or in combination. Among these, epoxy resins are preferable from the viewpoint of an improvement in heat resistance and adhesion.

An epoxy resin that is solid at room temperature (e.g., bisphenol epoxy resin) and a flexible epoxy resin (e.g., epoxy resin that is liquid at room temperature (e.g., silicone-modified epoxy resin that is liquid at room temperature) may be used in combination as the thermosetting resin other than the epoxy resin (B). In this case, a photosensitive adhesive resin composition that exhibits heat resistance, flexibility, resolution when patterning an adhesive layer by photolithography, and adhesion in a well-balanced manner can be obtained.

The content of the thermosetting resin other than the epoxy resin (B) in the photosensitive resin composition according to one embodiment of the invention is not particularly limited, but is preferably 1 to 50 wt%, and particularly preferably 3 to 40 wt%. If the content of the thermosetting resin other than the epoxy resin (B) is less than 1 wt%, heat resistance may not be sufficiently improved. If the content of the thermosetting resin other than the epoxy resin (B) exceeds 50 wt%, toughness may not be sufficiently improved. A photosensitive resin composition that exhibits heat resistance and toughness in a well-balanced manner can be obtained by adjusting the content of the thermosetting resin other than the epoxy resin (B) in the photosensitive resin composition within the above range.

The photosensitive resin composition according to one embodiment of the invention may include, but not limited to, an alkali developability improver that improves alkali developability. Examples of the alkali developability improver include alkali developability improvers (e.g., phenolic hydroxyl group-containing compound) that are normally added to improve the alkali developability of a photosensitive resin composition.

The content of the alkali developability improver in the photosensitive resin composition according to one embodiment of the invention is not particularly limited, but is preferably 1 to 20 wt%, and particularly preferably 2 to 10 wt%. If the content of the alkali developability improver is within the above range, alkali developability and other properties can be obtained in a well-balanced manner.

The photosensitive resin composition according to one embodiment of the invention may include additives such as a UV absorber and a leveling agent insofar as the object of the invention is not impaired.

When it is particularly desired to reduce residues after patterning, it is preferable that the photosensitive resin composition according to one embodiment of the invention include an inorganic filler in an amount of 0 to 5 wt% based on the total amount of the photosensitive resin composition.

When heat resistance, dimensional stability, moisture resistance, and the like are particularly desired, the photosensitive resin composition according to one embodiment of the invention may further include an inorganic filler. When the photosensitive resin composition according to one embodiment of the invention includes an inorganic filler, releasability from a support film is improved when using the photosensitive resin composition to produce a photosensitive adhesive film.

Examples of the inorganic filler include talc, sintered clay, non-sintered clay, mica, silicates such as glass, oxides such as titanium oxide, alumina, fused silica (spherical fused silica and crushed fused silica), and silica powder (e.g., crystalline silica), carbonates such as calcium carbonate, magnesium carbonate, and hydrotalcite, hydroxides such as aluminum hydroxide, magnesium hydroxide, and calcium hydroxide, sulfates or sulfites such as barium sulfate, calcium sulfate, and calcium sulfite, borates such as zinc borate, barium metaborate, aluminum borate, calcium borate, and sodium borate, nitrides such as aluminum nitride, boron nitride, and silicon nitride, and the like. These inorganic fillers may be used either individually or in combination. Among these inorganic fillers, fused silica and a silica powder (e.g., crystalline silica) are preferable, and spherical fused silica is particularly preferable.

When the photosensitive resin composition according to one embodiment of the invention includes an inorganic filler, a cured product of the photosensitive resin composition exhibits improved heat resistance, moisture resistance, strength, and the like, and releasability from a protective film is improved when using the photosensitive resin composition to produce a photosensitive adhesive film. The shape of the inorganic filler is not particularly limited, but is preferably a sphere. This makes it possible to provide a photosensitive resin composition that does not have anisotropy in properties and is suitably used for an adhesive layer of a photosensitive adhesive film.

The average particle size of the inorganic filler is not particularly limited, but is preferably 5 to 50 nm, and particularly preferably 10 to 30 nm. If the average particle size of the inorganic filler is less than 5 nm, the inorganic filler may aggregate, so that a decrease in strength may occur. If the average particle size of the inorganic filler exceeds 50 nm, resolution of an adhesive layer by exposure and photolithography may decrease.

The photosensitive resin composition according to one embodiment of the invention may be used to form the spacer 4 of the light-receiving device 100 shown in FIG 1, for example. The photosensitive resin composition according to one embodiment of the invention exhibits thermal adhesion after photo-curing that is required for the spacer 4.

### (Photosensitive adhesive film)

The photosensitive resin composition according to one embodiment of the invention may be used to form the spacer 4. For example, a layer of the photosensitive resin composition according to one embodiment of the invention is formed on the substrate 1. The photosensitive resin composition is exposed via a mask, and developed using an alkaline developer to form a pattern. The transparent substrate is thermocompression-bonded to the pattern of the photosensitive resin composition, and the photosensitive resin composition (photosensitive adhesive film) is cured by heating to form the spacer 4. The light-receiving device 100 is thus obtained.

A layer of the photosensitive resin composition according to one embodiment of the invention may be formed on the substrate 1 by applying the photosensitive resin composition according to one embodiment of the invention in the form of a paste to the substrate 1, or laminating the photosensitive resin composition according to one embodiment of the invention in the form of a film (photosensitive adhesive film) on the substrate 1, for example. It is preferable to laminate the photosensitive resin composition according to one embodiment of the invention in the form of a film on the substrate 1 due to excellent microfabricatability and the ability to easily retain a constant thickness of the spacer 4.

For example, the photosensitive adhesive film according to one embodiment of the invention may be obtained by dissolving the photosensitive resin composition according to one embodiment of the invention in an appropriate organic solvent (e.g., N-methyl-2-pyrrolidone, anisole, methyl ethyl ketone, toluene, or ethyl acetate) to prepare a solution, applying the solution to a support film or the like, and drying the solution to remove the organic solvent.

When forming the spacer 4 of the light-receiving device 100 shown in FIG 1 using the photosensitive resin composition according to one embodiment of the invention, the spacer 4 exhibits excellent dimensional stability (stability of the height in the direction Z). Therefore, the resulting light-receiving device 100 exhibits an excellent imaging capability (imaging capability with respect to image distortion). Since the spacer 4 formed using the photosensitive resin composition according to one embodiment of the invention exhibits excellent sealing ability (i.e., prevents entrance of foreign matter such as dust and dirt into the hollow area), the resulting light-receiving device 100 exhibits an excellent imaging capability (imaging capability with respect to image defect (dark sport)).

The light-receiving device 100 may suitably be used for a CCD image sensor, a CMOS image sensor, a pressure sensor, a piezoelectric sensor, an acceleration sensor, and the like.

### EXAMPLES

The invention is further described below by way of examples and comparative examples. Note that the invention is not limited to the following examples.

### Example 1

### 1. Synthesis of alkali-soluble resin (A-2) including photopolymerizable double bond and alkali-soluble group (methacryl-modified bisphenol A phenol novolac resin MPN001)

500 g of a solution of a bisphenol A novolac resin ("Phenolite LF-4871" manufactured by DIC Corporation) in MEK (solid content: 60%) were put in a 2L flask. After the addition of 1.5 g of tributylamine (catalyst) and 0.15 g of hydroquinone (polymerization inhibitor), the mixture was heated to 100°C. 180.9 g of glycidyl methacrylate was delivered by drops into the mixture over 30 minutes, and the mixture was stirred (reacted) at 100°C for 5 hours to obtain a methacryl-modified bisphenol A novolac resin (modification rate: 50%) having a nonvolatile content of 74%.

### 2. preparation of resin varnish

3 wt% of a phenol novolac resin ("PR53647" manufactured by Sumitomo Bakelite Co., Ltd.) (alkali-soluble resin (A-1) that does not include a photopolymerizable double bond, but includes an alkali-soluble group), 50 wt% of the methacryl-modified bisphenol A phenol novolac resin (MPN001) (alkali-soluble resin (A-2) that includes a photopolymerizable double bond and an alkali-soluble group), 15 wt% of HP4700 (manufactured by DIC Corporation, epoxy resin having a naphthalene skeleton shown by the formula (3)), 2 wt% of Irgacure 651 (manufactured by Ciba Specialty Chemicals Co., Ltd.) (photoinitiator (C)), 5 wt% of a methacrylic acid adduct of diglycidyl ether of a bisphenol A propylene oxide (2 mol) adduct ("Epoxy Ester 3002M" manufactured by Kyoeisha Chemical Co., Ltd. (formula (7-1))) (photopolymerizable compound (D-1) that includes a hydrophilic group or a hydrophilic structure), 20 wt% of trimethylolpropane trimethacrylate ("Light Ester TMP" manufactured by Kyoeisha Chemical Co., Ltd.) (trifunctional photopolymerizable compound) (polyfunctional photopolymerizable compound (D-2)), and 5 wt% of silicone epoxy resin ("BY16-115" manufactured by Dow Corning Toray Silicone Co., Ltd.) were dissolved in methyl ethyl ketone (MEK) (manufactured by Daishin-Chemical Co., Ltd.) to prepare a resin varnish.

### 3. Preparation of photosensitive adhesive film

The resin varnish was applied to a support substrate polyester film ("RL-07" manufactured by Teijin DuPont films Ltd., thickness: 38 µm) using a comma coater, and dried at 70°C for 10 minutes to obtain a photosensitive adhesive film having a thickness of 50 µm.

### 4. Production of light-receiving device

The photosensitive adhesive film was laminated to a 6-inch wafer using a base substrate provided with a microlens array by using a laminator set at 60°C. The photosensitive adhesive film was exposed using a negative type mask and an exposure system, and developed to form a patterned sample. The pattern was formed to enclose the light-receiving section on each solid-state imaging device (width: 100 µm) in the shape of a frame. The photosensitive adhesive film was exposed at a dose of 700 mJ/cm² (wavelength: 365 nm), and developed at a spray pressure of 0.2 MPa for 60 seconds using 3% tetramethylammonium hydroxide (TMAH). The patterned sample was diced, and thermocompression-bonded (80°C, 5 seconds, 0.2 MPa) to a glass substrate (5×4×0.5 mm). The sample was cured at 180°C for 2 hours, and placed on (connected to) an evaluation substrate to obtain an evaluation sample (light-receiving device).

### Example 2

A photosensitive adhesive film and a light-receiving device were obtained in the same manner as in Example 1, except for changing the amount of the methacryl-modified bisphenol A phenol novolac resin (MPN001) (alkali-soluble resin (A-2) that includes a photopolymerizable double bond and an alkali-soluble group) from 50 wt% to 60 wt%, and changing the amount of HP4700 (manufactured by DIC Corporation) (epoxy resin (B) having a naphthalene skeleton) from 15 wt% to 5 wt%.

### Example 3

A photosensitive adhesive film and a light-receiving device were obtained in the same manner as in Example 1, except for changing the amount of the methacryl-modified bisphenol A phenol novolac resin (MPN001) (alkali-soluble resin (A-2) that includes a photopolymerizable double bond and an alkali-soluble group) from 50 wt% to 20 wt%, and changing the amount of HP4700 (manufactured by DIC Corporation) (epoxy resin (B) having a naphthalene skeleton) from 15 wt% to 45 wt%.

### Example 4

A photosensitive adhesive film and a light-receiving device were obtained in the same manner as in Example 1, except for using 15 wt% of E1032H60 (manufactured by Japan Epoxy Resins Co., Ltd.) (epoxy resin (B) having a triphenylmethane skeleton) instead of 15 wt% of HP4700 (manufactured by DIC Corporation) (epoxy resin (B) having a naphthalene skeleton).

Note that E1032H60 is a mixture of epoxy resins having a triphenylmethane skeleton shown by the general formula (2) that differ in n. The average value of n of the epoxy resins having a triphenylmethane skeleton shown by the general formula (2) in the mixture was 0.2.

### Example 5

A photosensitive adhesive film and a light-receiving device were obtained in the same manner as in Example 4, except for changing the amount of the methacryl-modified bisphenol A phenol novolac resin (MPN001) (alkali-soluble resin (A-2) that includes a photopolymerizable double bond and an alkali-soluble group) from 50 wt% to 60 wt%, and changing the amount of E 1 032H60 (manufactured by Japan Epoxy Resins Co., Ltd.) (epoxy resin (B) having a triphenylmethane skeleton) from 15 wt% to 5 wt%.

### Example 6

A photosensitive adhesive film and a light-receiving device were obtained in the same manner as in Example 4, except for changing the amount of the methacryl-modified bisphenol A phenol novolac resin (MPN001) (alkali-soluble resin (A-2) that includes a photopolymerizable double bond and an alkali-soluble group) from 50 wt% to 20 wt%, and changing the amount of E1032H60 (manufactured by Japan Epoxy Resins Co., Ltd.) (epoxy resin (B) having a triphenylmethane skeleton) from 15 wt% to 45 wt%.

### Example 7

A photosensitive adhesive film and a light-receiving device were obtained in the same manner as in Example 1, except for changing the amount of HP4700 (manufactured by DIC Corporation) (epoxy resin (B) having a naphthalene skeleton) from 15 wt% to 5 wt%, and adding 10 wt% of E1032H60 (manufactured by Japan Epoxy Resins Co., Ltd.) (epoxy resin (B) having a triphenylmethane skeleton).

### Example 8

A photosensitive adhesive film and a light-receiving device were obtained in the same manner as in Example 1, except for changing the amount of HP4700 (manufactured by DIC Corporation) (epoxy resin (B) having a naphthalene skeleton) from 15 wt% to 10 wt%, and adding 5 wt% of E1032H60 (manufactured by Japan Epoxy Resins Co., Ltd.) (epoxy resin (B) having a triphenylmethane skeleton).

### Example 9

A photosensitive adhesive film and a light-receiving device were obtained in the same manner as in Example 1, except for using 15 wt% of HP4032D (manufactured by DIC Corporation (formula (5-1))) (epoxy resin (B) having a naphthalene skeleton) instead of 15 wt% of HP4700 (manufactured by DIC Corporation) (epoxy resin (B) having a naphthalene skeleton).

### Example 10

A photosensitive adhesive film and a light-receiving device were obtained in the same manner as in Example 1, except for using 5 wt% of an acrylic acid adduct of diglycidyl ether of a bisphenol A propylene oxide (2 mol) adduct ("Epoxy Ester 3002A" manufactured by Kyoeisha Chemical Co., Ltd. (formula (7-2))) (photopolymerizable compound (D-1) that includes a hydrophilic group or a hydrophilic structure) instead of 5 wt% of a methacrylic acid adduct of diglycidyl ether of a bisphenol A propylene oxide (2 mol) adduct ("Epoxy Ester 3002M" manufactured by Kyoeisha Chemical Co., Ltd. (formula (7- 1))) (photopolymerizable compound (D-1) that includes a hydrophilic group or a hydrophilic structure).

### Example 11

A photosensitive adhesive film and a light-receiving device were obtained in the same manner as in Example 1, except for using 20 wt% of pentaerythritol triacylate ("Light Ester PE-3A" manufactured by Kyoeisha Chemical Co., Ltd.) (polyfunctional photopolymerizable compound (D-2)) instead of 20 wt% of trimethylolpropane trimethacrylate ("Light Ester TMP" manufactured by Kyoeisha Chemical Co., Ltd.) (trifunctional photopolymerizable compound) (polyfunctional photopolymerizable compound (D-2)).

### Example 12

A photosensitive adhesive film and a light-receiving device were obtained in the same manner as in Example 4, except for changing the amount of the methacryl-modified bisphenol A phenol novolac resin (MPN001) (alkali-soluble resin (A-2) that includes a photopolymerizable double bond and an alkali-soluble group) from 50 wt% to 47 wt%, and adding 3 wt% of silica ("SO-E5" manufactured by Admatechs Co., Ltd.) (filler).

### Example 13

A photosensitive adhesive film and a light-receiving device were obtained in the same manner as in Example 1, except for using 45 wt% of a bisphenol A novolac resin ("Phenolite LF-4871" manufactured by DIC Corporation) (alkali-soluble resin (A-1) that does not include a photopolymerizable double bond and an alkali-soluble group) instead of 50 wt% of the methacryl-modified bisphenol A phenol novolac resin (MPN001) (alkali-soluble resin (A-2) that includes a photopolymerizable double bond and an alkali-soluble group), and changing the amount of trimethylolpropane trimethacrylate ("Light Ester TMP" manufactured by Kyoeisha Chemical Co., Ltd.) (trifunctional photopolymerizable compound) (polyfunctional photopolymerizable compound (D-2)) from 20 wt% to 25 wt%.

### Example 14

Aphotosensitive adhesive film and a light-receiving device were obtained in the same manner as in Example 1, except for changing the amount of the methacryl-modified bisphenol A phenol novolac resin (MPN001) (alkali-soluble resin (A-2) that includes a photopolymerizable double bond and an alkali-soluble group) from 50 wt% to 48 wt%, and using 27 wt% of 1,6-hexanediol dimethacrylate ("Light Ester 1.6HX" manufactured by Kyoeisha Chemical Co., Ltd.) instead of 5 wt% of a methacrylic acid adduct of diglycidyl ether of a bisphenol A propylene oxide (2 mol) adduct ("Epoxy Ester 3002M" manufactured by Kyoeisha Chemical Co., Ltd.) and 20 wt% of trimethylolpropane trimethacrylate ("Light Ester TMP" manufactured by Kyoeisha Chemical Co., Ltd.), as a photopolymerizable compound (D) .

### Comparative Example 1

A photosensitive adhesive film and a light-receiving device were obtained in the same manner as in Example 1, except for using 15 wt% of Ep-1001 (manufactured by Japan Epoxy Resins Co., Ltd.) (epoxy resin having a bisphenol A skeleton) instead of 15 wt% of HP4700 (manufactured by DIC Corporation) (epoxy resin (B) having a naphthalene skeleton).

The structure of Ep-1001 is shown by the following formula (10).

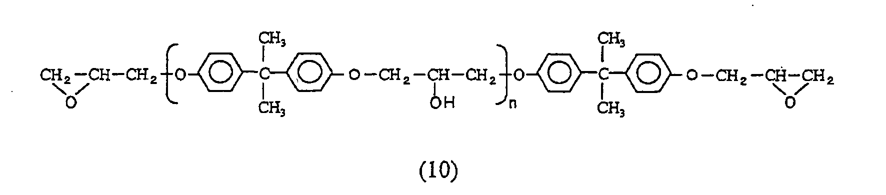

### Comparative Example 2

A photosensitive adhesive film and a light-receiving device were obtained in the same manner as in Example 1, except for using 15 wt% of EOCN-1020-70 (manufactured by Nippon Kayaku Co., Ltd.) (cresol novolac epoxy resin) instead of 15 wt% of HP4700 (manufactured by DIC Corporation) (epoxy resin (B) having a naphthalene skeleton).

The photosensitive adhesive films and the light-receiving devices obtained in the examples and the comparative examples were evaluated as described below. The evaluation items and the evaluation methods are given below. The evaluation results are shown in Tables 1 to 3.

### 1. Developability

The photosensitive adhesive film was laminated (60°C, 0.3 m/min) on a semiconductor wafer, exposed (700 mJ/cm²) using a pattern mask so that a resin spacer remained in a grid shape, and developed (0.2 MPa, 150 sec) using 2.3% TMAH. The resulting grid pattern was observed using an optical microscope (magnification: 1000) to evaluate the presence or absence of residues in accordance with the following standard.
Excellent: No residue was observed.
Good: Some residues were observed.
Fair: Residues were observed to an impractical level.
Bad: A large number of residues were observed.

The mask pattern was grid designed so that the resin width was 1.2 mm and the interval was 5 mm.

### 2. Shape retention capability

An 8-inch wafer provided with a light-receiving element and an 8-inch transparent substrate were thermocompression-bonded. A flow (degree of deformation) of the frame was observed using an electron microscope (magnification: 5000) to evaluate the presence or absence of deformation and delamination.
Excellent: No change in dimensions of the frame due to thermocompression-bonding was observed.
Good: A change in dimensions of the frame due to thermocompression-bonding was observed to some extent (a significant change in shape was not observed).
Fair: A change in dimensions of the frame due to thermocompression-bonding was observed.
Bad: A significant change in dimensions and shape of the frame due to thermocompression-bonding was observed.

### 3. Condensation of dew on light-receiving device

The light-receiving device was put in a high-temperature/high humidity bath (temperature: 85°C, humidity: 85%) up to 1000 hours. The light-receiving device was then removed from the high-temperature/high humidity bath, and condensation of dew (waterdrops or cloudiness) on the glass surface in the hollow area of the light-receiving device was immediately observed using a microscope (magnification: 50). ┘
Excellent: Condensation of dew was not observed after 1000 hours.
Good: Condensation of dew was not observed after 500 hours, but was observed after 1000 hours.
Bad: Condensation of dew was observed after 500 hours.

### 4. Reliability of light-receiving device

The light-receiving device was subjected to 1000 cycles (n=10) of a temperature cycle test (1cycle : at -55°C for 1 hour and at 125°C for 1 hour). The presence or absence of cracks and delamination was evaluated using an electron microscope (magnification: 5000) in accordance with the following standard.
Good: Cracks and delamination were not observed in each sample.
Bad: Cracks and delamination were observed in three or more samples.

**TABLE 1**

| | | Example 1 | Example 2 | Example 3 | Example 4 | Example 5 | Example 6 | Example 7 |
|---|---|---|---|---|---|---|---|---|
| Alkali-soluble resin (A) | | | | | | | | |
| Phenol novolac resin (A-1) | PR53647 | 3.0 | 3.0 | 3.0 | 3.0 | 3.0 | 3.0 | 3.0 |
| Methacryl-modified bisphenol A novolac resin (A-2) Epoxy resin (B) | MPN001 | 50.0 | 60.0 | 20.0 | 50.0 | 60.0 | 20.0 | 50.0 |
| Epoxy resin having naphthalene skeleton | HP4700 | 15.0 | 5.0 | 45.0 | | | | 5.0 |
| | HP4032D | | | | | | | |
| Epoxy resin having triphenylmethane skeleton | E1032H60 | | | | 15.0 | 5.0 | 45.0 | 10.0 |
| Bisphenol A epoxy resin | EP-1001 | | | | | | | |
| Cresol novolac epoxy resin | EOCN-1020-70 | | | | | | | |
| Photoinitiator (C) | Irgacure 651 | 2.0 | 2.0 | 2.0 | 2.0 | 2.0 | 2.0 | 2.0 |
| Photopolymerizable resin (D) | | | | | | | | |
| Photopolymerizable resin (D-1) including hydrophilic group or hydrophilic structure | | | | | | | | |
| Epoxy ester | Epoxy Ester 3002M | 5.0 | 5.0 | 5.0 | 5.0 | 5.0 | 5.0 | 5.0 |
| Epoxy ester | Epoxy Ester 3002.A | | | | | | | |
| Polyfunctional Photopolimerizable compound (D-2) | | | | | | | | |
| Trimethylolpropane trimethacrylate | Light Ester TMP | 20.0 | 20.0 | 20.0 | 20.0 | 20.0 | 20.0 | 20.0 |
| Pentacrythrilol triacylate | Light Ester PE-3A | | | | | | | |
| 1,6-Hexanediol dimethacrylate (D) | Light Ester 1.6HX | | | | | | | |
| Silicone-modified epoxy resin | BY16-115 | 5.0 | 5.0 | 5.0 | 5.0 | 5.0 | 5.0 | 5.0 |
| Filler | | | | | | | | |
| Sillen | 50.E5 | | | | | | | |
| Total | | 100.0 | 100.0 | 100.0 | 100.0 | 100.0 | 100.0 | 100.0 |
| Evaluation results | | | | | | | | |
| Developability Spacer shape retention capability | | Excellent. | Excellent | Good | Excellent | Excellent | Good | Excellent |
| Condensation of dew | | Excellent | Excellent | Good | Excellent | Excellent | Good | Excellent |
| | | Excellent | Good | Excellent | Excellent | Good | Excellent | Excellent |
| Reliability of light-receiving device | | Excellent | Good | Excellent | Excellent | Good | Excellent | Excellent |

**TABLE 2**

| | | Example 8 | Example 9 | Example 10 | Example 11 | Example 12 | Comparative Example 1 | Comparative Example 2 |
|---|---|---|---|---|---|---|---|---|
| Alkali-soluble resin (A) | | | | | | | | |
| Phenol novolac resin (A-1) | PR53647 | 3.0 | 3.0 | 3.0 | 3.0 | 3.0 | 3.0 | 3.0 |
| Methacryl-modified bisphenol A novolac resin (A-2) | MPN001 | 50.0 | 50.0 | 50.0 | 50.0 | 47.0 | 50.0 | 50.0 |
| Epoxy resin (B) | | | | | | | | |
| Epoxy resin having naphthalene skeleton | HP4700 | 10.0 | | 15.0 | 15.0 | 15.0 | | |
| | HP4032D | | 15.0 | | | | | |
| Epoxy resin having triphenylmethane skeleton | EI032H60 | 5.0 | | | | | | |
| Bisphenol A epoxy resin | EP-1001 | | | | | | 15.0 | |
| Cresol novolac epoxy resin | EOCN-1020-70 | | | | | | | 15.0 |
| Photoinitiator (C) | Irgacure 651 | 2.0 | 2.0 | 2.0 | 2.0 | 2.0 | 2.0 | 2.0 |
| Photopolymerizable resin (D) | | | | | | | | |
| Photopolymerizable resin (D-1) including hydrophilic group or hydrophilic structure | | | | | | | | |
| Epoxy ester | Epoxy Ester 3002M | 5.0 | 5.0 | | 5.0 | 5.0 | 5.0 | 5.0 |
| Epoxy ester | Epoxy Ester 3002A | | | 5.0 | | | | |
| Polyfunctional Photopolimerisable compound (D-2) | | | | | | | | |
| Trimethylolpropane trimethacrylate | Light Ester TMP | 20.0 | 20.0 | 20.0 | | 20.0 | 20.0 | 20.0 |
| Pentacrythritol triacylate | Light Ester PE-3A | | | | 20.0 | | | |
| 1,6-Hexanedio dimethacrylate (D) | Light Ester 1.6HX | | | | | | | |
| Silicone-modified epoxy resin | BY16-IL5 | 5.0 | 5.0 | 5.0 | 5.0 | 5.0 | 5.0 | 5.0 |
| Filler | | | | | | | | |
| Silica | SO.E5 | | | | | 3.0 | | |
| Total | | 100.0 | 100.0 | 100.0 | 100.0 | 100.0 | 100.0 | 100.0 |
| Evaluation results | | | | | | | | |
| Developability | | Excellent | Excellent | Excellent | Excellent | Good | Excellent | Excellent |
| Spacer shape retention capability | | Excellent | Excellent | Excellent | Excellent | Excellent | Excellent | Excellent |
| Condensation of dew | | Excellent | Excellent | Excellent | Excellent | Excellent | Bad | Bad |
| Reliability of light-receiving device | | Excellent | Excellent | Excellent | Excellent | Excellent | Bad | Bad |

**TABLE 3**

| | | Example 13 | Example 14 |
|---|---|---|---|
| Alkali-soluble resin (A) | | | |
| Phenol novolac resin (A-1) | PR53647 | 3.0 | 3.0 |
| Bisphenol A novolac resin (A-1) | Phenolite LF-4871 | 45.0 | |
| Methacryl-modified bisphenol A novolac resin (A-2) | MPN001 | | 48.0 |
| Epoxy resin (B) | | | |
| Epoxy resin having naphthalene skeleton | HP4700 | 15.0 | 15.0 |
| | HP4032D | | |
| Epoxy resin having triphenylmethane skeleton | E1032H60 | | |
| Bisphenol A epoxy resin | EP-1001 | | |
| Cresol novolac epoxy resin | EOCN-1020-70 | | |
| Photoinitiator (C) | Irgacure 651 | 2.0 | 2.0 |
| Photopolymerizable resin (D) | | | |
| Photopolymerizable resin (D-I) including hydrophilic group or hydrophilic structure | | | |
| Epoxy ester | Epoxy Ester 3002M | 5.0 | |
| Epoxy ester | Epoxy Ester 3002A | | |
| Polyfunctional Phompolimerizable compound (D-2) | | | |
| Trimethylolpropane trimethacrylate | Light Ester TMP | 25.0 | |
| Pentacrythritol triacylate | Light Ester PE-3A | | |
| 1,6-Hexanediol dimethacrylate (D) | Light Ester 1.6HX | | 27.0 |
| Silicone-modified epoxy resin | BY16-115 | 5.0 | 5.0 |
| Filler | | | |
| Silica | SO-E5 | | |
| Total | | 100.0 | 100.0 |
| Evaluation results | | | |
| Developability | | Excellent | Excellent |
| Spacer shape retention capability | | Excellent | Excellent |
| Condensation of dew | | Excellent | Excellent |
| Reliability of light-receiving device | | Excellent | Excellent |

As shown in Table 1, the photosensitive adhesive films of Examples 1 to 14 had excellent results for condensation of dew, developability, and shape retention capability. The light-receiving devices of Examples 1 to 14 had excellent reliability.
- 1: Substrate on which semiconductor element is mounted
- 2: Transparent substrate
- 3: Space
- 4: Spacer
- 11: Semiconductor element
- 13: Bonding wire
- 100: Light-receiving device
- 111: Light-receiving element

### INDUSTRIAL APPLICABILITY

According to the invention, a light-receiving device that does not suffer from failure due to condensation of dew can be produced.

## Claims

1. A photosensitive resin composition comprising (A) an alkali-soluble resin, (B) an epoxy resin, and (C) a photopolymerization initiator, the epoxy resin (B) being an epoxy resin having a naphthalene skeleton and/or an epoxy resin having a triphenylmethane skeleton.

2. The photosensitive resin composition according to claim 1, wherein the epoxy resin (B) is an epoxy resin having a naphthalene skeleton shown by the following general formula (1) and/or an epoxy resin having a triphenylmethane skeleton shown by the following general formula (2),

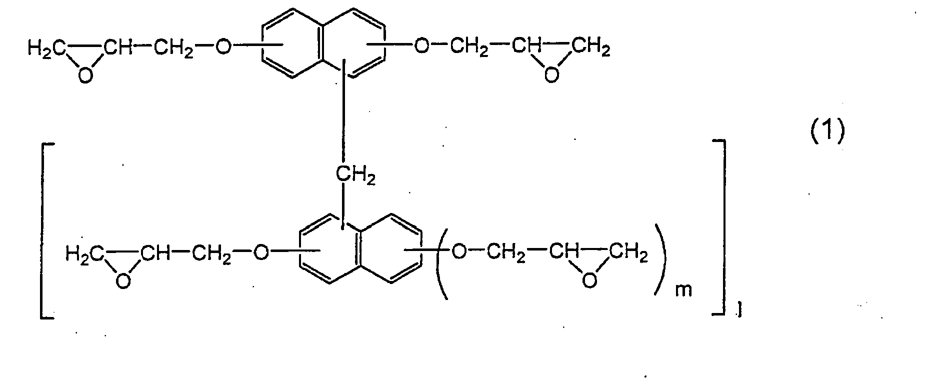

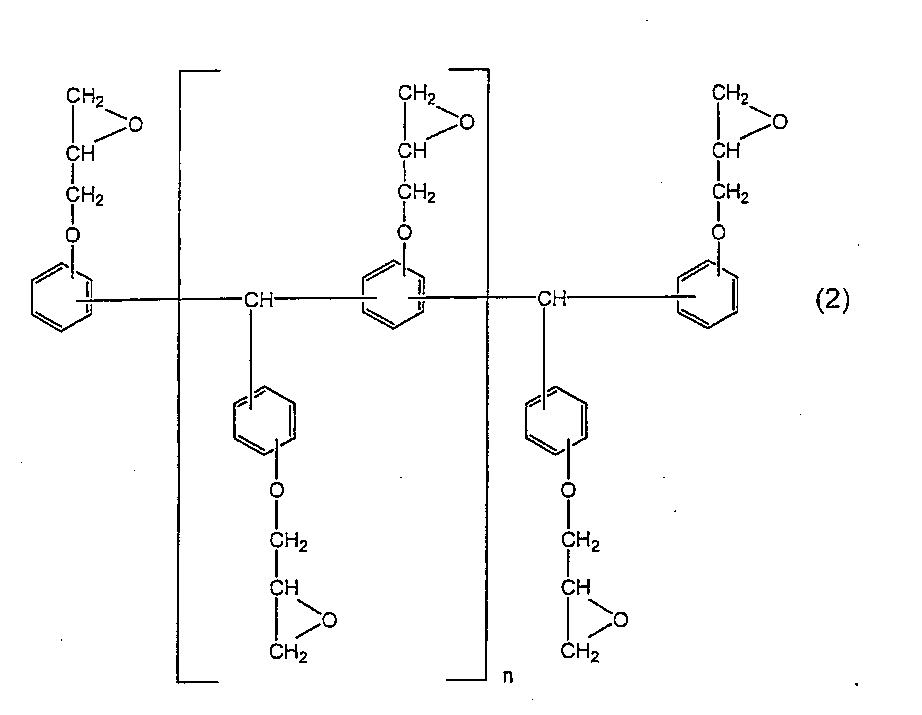

3. The photosensitive resin composition according to claim 1, wherein the epoxy resin (B) is an epoxy resin having a naphthalene skeleton shown by the following general formula (3) and/or a mixture of epoxy resins having a triphenylmethane skeleton shown by the general formula (2) that differ in n, the average value of n being 0 to 0.8,

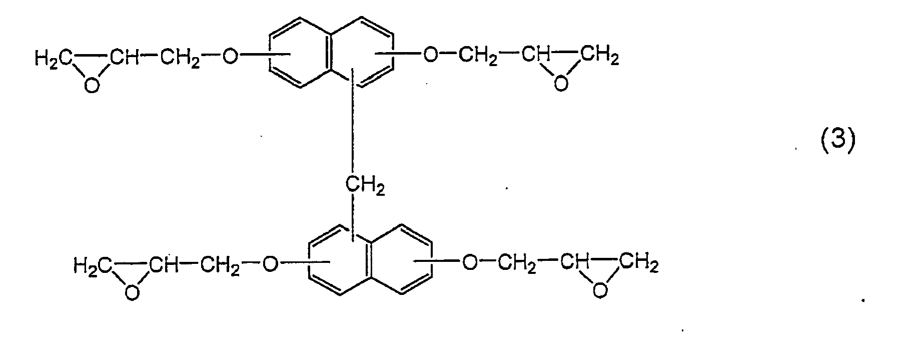

4. The photosensitive resin composition according to any one of claims 1 to 3, the composition including the epoxy resin (B) in an amount of 5 to 50 wt%.

5. The photosensitive resin composition according to any one of claims 1 to 4, wherein the alkali-soluble resin (A) includes a photopolymerizable double bond and an alkali-soluble group.

6. The photosensitive resin composition according to any one of claims 1 to 5, wherein the alkali-soluble resin (A) is a (meth)acryl-modified phenol resin.

7. The photosensitive resin composition according to any one of claims 1 to 6, further comprising a photopolymerizable compound that includes a hydrophilic group or a hydrophilic structure.

8. The photosensitive resin composition according to any one of claims 1 to 7, further comprising a polyfunctional photopolymerizable compound.

9. The photosensitive resin composition according to any one of claims 1 to 8, the composition including an inorganic filler in an amount of 0 to 5 wt%.

10. The photosensitive resin composition according to any one of claims 1 to 9, the composition being used to form a spacer of a light-receiving device, the light-receiving device including a substrate on which a semiconductor element is mounted, a transparent substrate that is placed opposite to the substrate, and the spacer that defines a space formed between the substrate and the transparent substrate.

11. A photosensitive adhesive film comprising the photosensitive resin composition according to any one of claims 1 to 9.

12. A light-receiving device including a substrate on which a semiconductor element is mounted, a transparent substrate that is placed opposite to the substrate, and a spacer that defines a space formed between the substrate and the transparent substrate, the spacer being a cured product of the photosensitive resin composition according to any one of claims 1 to 9.
